# EUROPEAN PATENT SPECIFICATION

(11) **EP 3 238 277 B1**
(45) Date of publication and mention of the grant of the patent: **26.09.2018**
(21) Application number: 15804483.4
(22) Date of filing: 03.12.2015
(51) Int. Cl.: H01L 31/18, H01L 31/0236, H01L 21/3065

(54) **PROCESS FOR THE MANUFACTURE OF SOLAR CELLS**
VERFAHREN ZUR HERSTELLUNG VON SOLARZELLEN
PROCESSUS DE FABRICATION DE CELLULES SOLAIRES

(30) Priority: 22.12.2014 EP 14199551
(43) Date of publication of application: 01.11.2017
(73) Proprietor: Solvay SA, 1120 Bruxelles (BE)
(72) Inventor: PITTROFF, Michael, 30539 Hannover (DE); SCHWARZE, Thomas, 31275 Ahlten (DE)
(74) Representative: Mross, Stefan P.M.
(86) International application number: PCT/EP2015/078463
(87) International publication number: WO 2016/102165

(56) References cited:
- WO-A1-2012/145473
- JP-A- 2010 245 405
- US-A1- 2010 288 330

## Description

This application claims priority to European application No. 14199551.4 filed 22nd December 2014. The present invention relates to a method for manufacturing a solar cell from a silicon wafer comprising a step of etching the silicon wafer with specific gas mixtures comprising fluorine, hydrogen fluoride, one or more inert gases and optionally one or more a further gases.

Solar cells are applied to convert solar light into electric current. They are usually manufactured from monocrystalline blocks of boron-doped silicon (P-type doping) or from cast silicon ingots (polycrystalline silicon, P-type doped with boron) by sawing wafers in desired size from the bulk material.

The wafers thus obtained can optionally be treated with elemental fluorine (F₂) or carbonyl fluoride (COF₂) as described in WO 2009/092453.

Document JP 2010 245405 A discloses a surface roughening of silicon substrate with a mixture containing a fluorine-type reactive gas (such as HF, COF₂, or F₂), an oxidizing reactive gas and inert gas. Document WO 2012/145473 A1 discloses a method for etching and texturing of silicon surfaces with an etching mixture containing a fluorine gas (such as F₂) and an inert gas (such as Ar). However, there is still a need for improved methods for the modification of the surface of a silicon wafer.

Now therefore, the present invention provides methods that advantageously lead to an improved etch rate, an improved etch depth into the silicon wafer, and/or an improved surface texturing. The solar cells thus provided show advantageously an increased efficiency and/or an increased durability.

Accordingly, the present invention concerns in a first aspect a method for manufacturing a solar cell from a silicon wafer comprising a step of etching the silicon wafer with a gas mixture consisting of 0.1 to 20 vol% F₂, 2.5 to 1000 ppmv HF, optionally a further gas with one or more inert gases being the balance to 100 vol%.

In a preferred embodiment, the gas mixture consists of 0.5 to 5 vol% F₂, 5 to 100 ppmv HF with one or more inert gases being the balance to 100 vol%, more preferably the gas mixture consists of 1 to 5 vol% F₂, 10 to 50 ppmv HF with one or more inert gases being the balance to 100 vol%.

The term "ppmv" is intended to denote parts per million by volume, i.e. 1 part of volume to 1 million parts of volume. Likewise, the term "vol%" is intended to denote a certain percentage of the total volume of the gas mixture.

The gas mixture can be formed in the reactor by introducing the discrete single components into the reactors through a static mixer by themselves, or a gas mixture of the individual components is formed before introducing it into the reactor. If the gases are introduced in such a premixed form into the reactor, a homogenous or near-homogenous mixture can be provided throughout the reactor chamber. In general, the gas mixture can be supplied from pressurized bottles. In such pressurized bottles, a homogenous mixture forms. It is also possible to introduce the gas constituents separately into the reactor. It is also possible to introduce a premixed gas mixture with some of the components together with another gas or gas mixture simultaneously into the reactor.

In the context of this invention, the term "gas mixture" denotes premixed gas mixtures as well as mixtures created in the plasma reactor. It should be noted that the HF in the gas mixture can be added as neat HF to a preformed gas mixture of or more of the other constituents. Alternatively, the HF can also be provided by adding the corresponding amount of water/moisture to the fluorine-comprising gas mixture, upon which HF is formed as a reaction product of the reaction of F₂ and water. In this case, one or more further gases, including the other reaction products from this reaction, e.g. oxygen, are comprised in the gas mixture.

The atmosphere at the production site, i.e. the clean rooms, for the silicon wafers is generally controlled to maintain a standard temperature and moisture. Thus, the HF can also be generated at a controlled level by passing a gas mixture through a plastic tube, preferably made from PTFE or PVDF, for a defined time and tube length. As the conditions in the clean rooms are constant, the moisture uptake is constant as well. Thus, instead of providing a gas cylinder with a certain specific water or HF concentration, the gas mixture or one of its components, e.g. the inert gas, can be passed through the plastic tube for a specified time and tube length. The moisture is then converted to HF by reaction with F₂ as explained above. The alternative reduces the cost as for example commercially available electronic grade N₂ can be used without the need to mix it with a certain amount of HF or water.

The term "inert gas" is intended to denote a gas that does not react with the other gases present and neither with the solar wafer. Suitable examples include N₂, Ar, He, Ne, Kr and mixtures thereof, preferred are N₂ and/or Ar, notably N₂.

Additional gases may optionally also be present in the mixture. Suitable examples include O₂, COF₂, N₂O, SF₆, NF₃.

Additional gases may also include NO, NO₂, and NO₃.

Preferred additional gases are oxygen-bearing gases like N₂O, NO, NO₂ and NO₃. The volume ratio of F₂ to the additional gases, preferably the oxygen bearing additional gases, is in a range of 20:1 to 1:1, more preferably 10:1 to 3:1, most preferably around 6:1.

The addition of Oxygen carries gas increases the m-Si etching rate and depeness. and mixtures thereof.

In another preferred embodiment, the step of etching the silicon wafer with the gas mixture is a step of texturing the surface of the solar wafer said step being suitable to increase the efficiency of the solar cell. Without being bound to a theory, the texturing step is believed to created craters of defined depths and shape in the silicon wafer material. This texturing step enables the silicon wafer material to absorb a greater proportion of the sun light.

It has been surprisingly found that the use of a defined amount of HF as specified in the present invention has an advantageous effect on the etch rate as well as the etch depth achieved with the inventive gas mixtures. Additionally, the presence of the HF in the gas mixture leads to a texture on the surface of the silicon wafer which further leads to an improved efficiency of the solar cells prepared from these silicon wafers. It is believed that the texturing of the wafer surface by the etching reduces the reflectivity and thus enhances the effectivity of the solar cell. Reflectivity is considered reduced if the total hemispherical reflectivity (averaged over all wavelengths) expressed by the intensity of incident light divided by reflected light is smaller for the surface-treated silicon wafer in relation to the untreated silicon wafer.

Without being bound to a theory, it is believed that the HF has at least partially a catalytic activity in the etching process. The HF is believed to react faster with the SiO₂ of the silicon wafer, forming products including SiF₄ and water. The water formed can subsequently react with the fluorine present in the gas mixture to form additional amounts of HF.

The etching treatment is performed for a time which is sufficient to provide the desired texture of the surface for mass production in dry etching processes. Preferably, the treatment is performed for equal to or more than 1 second. Preferably, the treatment is performed for equal to or less than 10 minutes, preferably for equal to or less than 5 minutes. Etching is preferably performed until about equal to or more than 0.1 µm of the surface are etched away. Preferably, it is performed until equal to or less than 500 µm, preferably, until equal to or less than 100 µm are etched away from the surface, especially until equal to or less than 20 µm are etched away. Often, a few µm are etched away, for example equal to or less than 10 or even equal to or less than 5 µm.

The silicon wafer can be of 200 mm, 300 mm, 400 mm, or 500 mm diameter.

The flow rate of the gas mixture is chosen between 1.000 and 50.000 sccm, preferably 20.000 sccm.

The etching can also be applied to the rear side of the solar cell to improve adhesion of the electrodes which are applied, as is described below.

The etching can be performed on any conventional equipment used for such purpose. The etching can be performed thermally or assisted by a plasma source. Preferably, the etching is performed thermally.

During the etching treatment, the wafer might heat up. So, if needed, either the wafer can be cooled if a threat of overheating exists, or the treatment must be interrupted from time to time so that the wafer cools down. Preferably, the step of etching the silicon wafer with the gas mixture is performed at a temperature from 200 to 400 °C. Thus, the silicon wafer needs to either be heated to this temperature or cooled to this temperature. More preferably, the step is performed at a temperature of around 250 °C, 300 °C, or, or 350 °C.

The pressure inside the etching chamber is preferably atmospheric pressure, i.e. is chosen between 740 and 760 Torr. Alternatively, the etching can be performed at a pressure below atmospheric pressure, e.g. at 10, 20, 50, 100, 200, 300, 400, or 500 Torr.

The silicon wafers treated prepared according to the present invention can be further treated to produce a solar cell. Especially, contact electrodes are applied. These contact electrodes are needed to withdraw electric current (usually direct current) from the cell. A preferred way to apply contact electrodes is evaporating metal onto the wafer as mentioned in US-A 4249957. A contact electrode from titanium-palladium-silver is very suitable. There are alternative methods which can be used to apply contact electrodes. For example, a paste can be applied which contains conductive particles, e.g. silver particles, to form a pattern on the wafer, the wafer is fired, and a conductive pattern is formed on the wafer which functions as electrode. This alternative is described in EP-A-0 542148.

A solar cell obtained by the process of the present invention is also disclosed. In one embodiment, cells containing a wafer which was surface-etched have a very low degree of reflexivity. Also disclosed is a solar panel obtained by assembling a plurality of solar cells obtained in the process of the present invention. "A plurality" denotes at least two solar cells. The upper limit is given from practical reasons. Preferably, equal to or less than 10 solar cells, more preferably, at least 20 solar cells are assembled to provide a solar panel.

The following examples are intended to explain the invention further without intending to limit it.

### Examples :

### Example 1: Texturing of a silicon wafer

A 200 mm plain silicon wafer without structure is dry etched in a microwave plasma etcher manufactured by Secon Semiconductor Equipment GmbH, Austria. The wafers are weighed before and after etching, the difference in weight indicates the etch rate. The etch depth achieved by the texturing is measured by optical laser measuring and can be performed on a Proforma 200SA (MTI instruments inc.).

The wafer is placed in the etching chamber and the heater maintained a temperature of 300 °C. Thermal etching, i.e. etching with the plasma source being switched off, commences with a gas mixture consisting of 20 vol% F₂, 200 ppmv HF, and N₂ being the balance to 100 vol% at a flow rate of 20 sccm at atmospheric pressure (755 Torr). The thermal etching process is performed for 60 s. A control experiment is conducted using the same parameters as described above using an ultrapure gas mixture consisting of 20 vol% F₂ and 80 vol% N₂ with an HF content of below 1 ppm.

Etch depth analysis shows that the etch depth achieved with the gas mixture comprising 200 ppmv HF shows an up to fourfold improvement compared to the ultrapure gas mixture comprising 1 ppmv HF.

### Example 2: Applying electrodes to the treated wafer

A silicon wafer treated according to the procedure outlined in example 1 is further processes to apply electrodes as described in EP-A-0 542148. A paste containing silver and, as inorganic binder, lead oxide and silicon dioxide is applied on the front side of the wafer by screen printing according to the desired pattern of the electrode structure. On the back side, a similar electrode paste is applied which further contains aluminium. The wafer is then fired at around 800°C. The pattern is then galvanized in a bath containing silver chloride and sodium thiosulfate.

The solar cell thus manufactured shows an improved efficiency compared to a solar cell manufactured using untreated silicon wafers.

## Claims

1. A method for manufacturing a solar cell from a silicon wafer comprising a step of etching the silicon wafer with a gas mixture consisting of 0.1 to 20 vol% F₂, 2.5 to 1000 ppmv HF, optionally a further gas with one or more inert gases being the balance to 100 vol%.

2. The method according to claim 1 wherein the gas mixture consists of 0.5 to 5 vol% F₂, 5 to 100 ppmv HF with one or more inert gases being the balance to 100 vol%.

3. The method of claim 1 or 2 wherein the gas mixture consists of 1 to 5 vol% F₂, 10 to 50 ppmv HF with one or more inert gases being the balance to 100 vol%.

4. The method according to any one of claims 1 to 3 wherein the step of etching the silicon wafer with the gas mixture is a step of texturing the surface of the solar wafer said step being suitable to increase the efficiency of the solar cell.

5. The method according to any one of claims 1 to 4 wherein the one or more inert gas is chosen from N₂ or Ar, preferably the inert gas is nitrogen.

6. The method according to any one of claims 1 to 5 wherein the optionally further gas is chosen from O₂, N₂O, NO, NO₂, NO₃ and NF₃.

7. The method according to any one of claims 1 to 6 wherein the step of etching the silicon wafer with the gas mixture is performed thermally, preferably thermally at a temperature from 200 to 400 °C.

8. A method for manufacturing a solar panel wherein two or more solar cells manufactured by a method according to any one of claims 1 to 7 are assembled.

## Patentansprüche

1. Verfahren zur Herstellung einer Solarzelle aus einem Siliciumwafer, umfassend einen Schritt des Ätzens des Siliciumwafers mit einem Gasgemisch, das aus 0,1 bis 20 Vol.-% F₂, 2,5 bis 1000 ppmv HF, gegebenenfalls einem weiteren Gas mit einem oder mehreren Inertgasen, die den Ausgleich auf 100 Vol.-% bilden, besteht.

2. Verfahren gemäß Anspruch 1, wobei das Gasgemisch aus 0,5 bis 5 Vol.-% F₂, 5 bis 100 ppmv HF mit einem oder mehreren Inertgasen, die den Ausgleich auf 100 Vol.-% bilden, besteht.

3. Verfahren gemäß Anspruch 1 oder 2, wobei das Gasgemisch aus 1 bis 5 Vol.-% F₂, 10 bis 50 ppmv HF mit einem oder mehreren Inertgasen, die den Ausgleich auf 100 Vol.-% bilden, besteht.

4. Verfahren gemäß einem der Ansprüche 1 bis 3, wobei der Schritt des Ätzens des Siliciumwafers mit dem Gasgemisch ein Schritt des Texturierens der Oberfläche des Solarwafers ist, wobei der Schritt geeignet ist, die Leistungsfähigkeit der Solarzelle zu erhöhen.

5. Verfahren gemäß einem der Ansprüche 1 bis 4, wobei das eine oder die mehreren Inertgase ausgewählt sind aus N₂ und Ar, wobei das Inertgas vorzugsweise Stickstoff ist.

6. Verfahren gemäß einem der Ansprüche 1 bis 5, wobei das optionale weitere Gas ausgewählt ist aus O₂, N₂O, NO, NO₂, NO₃ und NF₃.

7. Verfahren gemäß einem der Ansprüche 1 bis 6, wobei der Schritt des Ätzens des Siliciumwafers mit dem Gasgemisch thermisch durchgeführt wird, vorzugsweise thermisch bei einer Temperatur von 200 bis 400 °C.

8. Verfahren zur Herstellung eines Solarpanels, wobei zwei oder mehr Solarzellen, die durch ein Verfahren gemäß einem der Ansprüche 1 bis 7 hergestellt sind, zusammengesetzt werden.

## Revendications

1. Procédé de fabrication d'une cellule solaire à partir d'une tranche de silicium comprenant une étape de gravure de la tranche de silicium avec un mélange gazeux composé de 0,1 à 20 % en volume de F₂, 2,5 à 1000 ppm en volume de HF, optionnellement un gaz supplémentaire avec un ou plusieurs gaz inertes pour le complément à 100 % en volume.

2. Procédé selon la revendication 1 dans lequel le mélange gazeux est composé de 0,5 à 5 % en volume de F₂, 5 à 100 ppm en volume de HF avec un ou plusieurs gaz inertes pour le complément à 100 % en volume.

3. Procédé de la revendication 1 ou 2 dans lequel le mélange gazeux est composé de 1 à 5 % en volume de F₂, 10 à 50 ppm en volume de HF avec un ou plusieurs gaz inertes pour le complément à 100 % en volume.

4. Procédé selon l'une quelconque des revendications 1 à 3 dans lequel l'étape de gravure de la tranche de silicium avec le mélange gazeux est une étape de texturation de la surface de la tranche solaire, ladite étape étant appropriée pour augmenter l'efficacité de la cellule solaire.

5. Procédé selon l'une quelconque des revendications 1 à 4 dans lequel le ou les gaz inertes sont choisis entre N₂ et Ar, de préférence le gaz inerte est l'azote.

6. Procédé selon l'une quelconque des revendications 1 à 5 dans lequel le gaz supplémentaire optionnel est choisi parmi O₂, N₂O, NO, NO₂, NO₃ et NF₃.

7. Procédé selon l'une quelconque des revendications 1 à 6 dans lequel l'étape de gravure de la tranche de silicium avec le mélange gazeux est effectuée thermiquement, de préférence thermiquement à une température de 200 à 400 °C.

8. Procédé de fabrication d'un panneau solaire dans lequel au moins deux cellules solaires fabriquées par un procédé selon l'une quelconque des revendications 1 à 7 sont assemblées.
